Europäisches Patentamt

European Patent Office

Office européen des brevets

(11) Numéro de publication: **0 286 884 B1**

# FASCICULE DE BREVET EUROPEEN

(45) Date de publication de fascicule du brevet:
**22.01.92**

(51) Int. Cl.5: **H03H  17/00**

(21) Numéro de dépôt: **88104731.0**

(22) Date de dépôt: **24.03.88**

(54) **Filtre numérique fonctionnant à fréquence intermédiaire.**

(30) Priorité: **26.03.87 FR 8704218**

(43) Date de publication de la demande:
**19.10.88 Bulletin  88/42**

(45) Mention de la délivrance du brevet:
**22.01.92 Bulletin  92/04**

(84) Etats contractants désignés:
**DE FR GB IT NL SE**

(56) Documents cités:
**US-A- 4 338 581**

**IEEE TRANSACTIONS ON ACOUSTICS, SPEECH, AND SIGNAL PROCESSING, vol. ASSP-28, no. 1, février 1980, pages 41-45, IEEE, New York, US; D.C. MUNCON, Jr. et al.: "Low-noise realizations for narrow-band recursive digital filters"**

**ELECTRONICS LETTERS, vol. 18, no. 17, 19 août 1982, pages 739-740, Londres, GB; J.R. JORDAN et al.: "Fir filter for generating multi-level signals from single-bit noise sequences"**

(73) Titulaire: **ALCATEL TELSPACE**
**5, rue Noel Pons**
**F-92734 Nanterre(FR)**

(72) Inventeur: **Argintaru, Lazare**
**103 avenue de Belvédère**
**F-93310 Le Pre Saint Gervais(FR)**
Inventeur: **Arnassand, Daniel**
**24 rue de Verdun**
**F-94230 Cachan(FR)**
Inventeur: **Leclair, Philippe**
**3 rue Persil**
**F-92160 Antony(FR)**

(74) Mandataire: **Weinmiller, Jürgen et al**
**Lennéstrasse 9 Postfach 24**
**W-8133 Feldafing(DE)**

## Description

L'invention concerne un filtre numérique fonctionnant à fréquence intermédiaire.

Les débits transmis par les faisceaux hertziens peuvent varier comme des multiples entiers du train numérique de base ; ce dernier étant de 256Kbit/s. C'est-à-dire par exemple : 512, 1024, 2048, ou 4096Kbit/s etc....

La transmission hertzienne est optimisée pour chaque débit par un filtre généralement placé en fréquence intermédiaire (à 70MHz le plus souvent) dont la bande passante est directement proportionnelle au débit à transmettre.

En fonction des débits on commute des filtres qui peuvent être de natures différentes :

- Filtres à quartz ou ondes de surface pour les petits débits.
- Filtres à constantes localisées pour les forts débits.

Ces techniques sont lourdes et coûteuses d'emploi.

L'article intitulé "Low-noise realizations for narrow-band recursive digital filters" et paru dans "IEEE transactions on acoustics, speech, and signal processing" (vol. ASSP-28, no. 1, février 1980, pages 41-45, IEEE, New-York, US. D.C. MUNCON, Jr. et al) décrit plusieurs structures faible-bruit pour filtres digitaux récursifs bandes étroites.

Les filtres numériques de l'art connu ont de nombreux avantages. Ils ont une grande souplesse d'emploi qui provient de leur adaptativité et de leur possibilité de réaliser des fonctions non linéaires, à partir des valeurs des coefficients de programmation.

De tels filtres présentent toutefois, l'inconvénient de comporter une structure telle qu'apparaissent des retards $Z^{-1}$ dus aux opérateurs inhérents au fonctionnement et des retards structurels dus aux additionneurs.

Les retards OT (opérateur temporel) $Z^{-1}$ sont liés au débit : temps bit. Les retards structurels $Z \oplus$ apparaissent comme des défauts et dégradent le fonctionnement des filtres.

EXEMPLE

$Z^{-1}$ à 2,048 Mbits $\simeq$ 500ns.
$Z \oplus$ à 70MHz $\simeq$ 14,5ns.

Ces retards structurels s'additionnenent et augmentent donc avec le nombre d'opérateurs.

Dans l'art connu ces filtres sont réalisés pour des fréquences de travail nettement inférieure à 10MHz.

L'invention a pour objet de pallier ces inconvénients.

La présente invention propose, à cet effet un filtre numérique fonctionnant à fréquence intermédiaire caractérisé en ce qu'il comprend :

- un filtre transverse;
- un filtre récursif ;
- un dispositif de mémorisation des différents coefficients des deux filtres ;
- un dispositif de conversion numérique-analogique situé en sortie de ce dispositif de mémorisation ;
- un dispositif d'adressage de ce dispositif de mémorisation ;
- un organe de commande de ce dispositif d'adressage ;

et en ce que le dispositif de conversion numérique-analogique reçoit en entrée les sorties parallèles du dispositif de mémorisation, et a ses sorties reliées respectivement aux n entrées du filtre transverse et aux n' entrées du filtre récursif, et en ce que le filtre transverse comprend une $n + 1^e$ entrée qui est l'entrée dudit filtre, la sortie de ce filtre transverse étant reliée à la première entrée d'un additionneur intermédiaire dont la sortie, qui constitue la sortie dudit filtre, est reliée à la $n' + 1^{ème}$ entrée du filtre récursif, la sortie de ce filtre récursif étant reliée à la deuxième entrée de l'additionneur intermédiaire.

Un tel filtre numérique est adapté au débit et fonctionne aux fréquences intermédiaires.

Avantageusement le filtre transverse et le filtre récursif sont de structures analogues, une telle structure comprenant n-1 éléments de retard fonctionnels RF(i) reliés en série avec n-1 additionneurs A(i), un additionneur étant disposé à la sortie de chaque élément de retard fonctionnel, n-1 éléments de retard structurels RS(i), et n multiplieurs à la première entrée desquels sont reliées n entrées C-(i) et dont l'autre entrée est reliée à la dernière entrée $C(n + 1)$, en ce que chaque élément de retard structurel RS(i) ayant une première entrée reliée à la sortie du multiplieur de rang immédiatement supérieur M (i + 1), une seconde entrée reliée à l'entrée de l'élément de retard fonctionnel de même rang RF(i), une troisième entrée reliée à la sortie du même élément de retard fonctionnel RF(i) et sa sortie reliée à la deuxième entrée de l'additionneur de même rang A(i), et en ce que le premier multiplieur M(1) ayant sa sortie reliée à l'entrée du premier élément de retard fonctionnel RF(1).

Avantageusement l'élément de retard structurel comprend un transistor FET bigrille dont l'une des grilles constitue la première entrée, et dont la seconde grille est reliée à la sortie d'un discriminateur de phase dont les deux entrées constituent respectivement la seconde et la troisième entrée dudit élément de retard, le drain dudit transistor étant relié à la masse, alors que sa source est reliée à un amplification-séparateur dont la sortie constitue la sortie dudit élément de retard.

Avantageusement l'élément de retard fonctionnel comporte en série :
- un échantillonneur ;
- un convertisseur analogique-numérique ;
- un registre à décalage ;
- un convertisseur numérique-analogique ;
- un amplificateur séparateur.

Les caractéristiques et avantages de l'invention ressortiront d'ailleurs de la description qui va suivre, à titre d'exemple non limitatif, en référence aux figures annexées sur lesquelles :
- la figure 1 est une représentation schématique sous la forme canonique d'un filtre numérique ;
- la figure 2 est une représentation schématique du filtre de l'invention ;
- les figures 3, 4 et 5 sont des représentations schématiques de parties constitutives du filtre de l'invention de la figure 2.

Un filtre numérique est l'équivalent d'une intégrale de convolution pour les systèmes linéaires continus.

Donc par définition de la transformée en Z on obtient l'écriture suivante :

$S(z) = A(z) \cdot E(z)$

$A(z)$ étant la fonction de filtrage.

$E(z)$ étant le signal.

$S(z) = \sum_{n}^{\epsilon} \sum_{i}^{\epsilon} A_i \cdot Z^{-i} \cdot e_{n-i} Z^{-(n-i)}$

avec $A(z)$ s'écrivant :

$$A(z) = \frac{\sum_{k=0}^{N} \beta_k z^{-k}}{\sum_{j=0}^{N} \alpha_j z^{-j}}$$

avec $\alpha_0 = 1$

$\alpha_j$ et $\beta_k$ étant les coefficients du filtre.

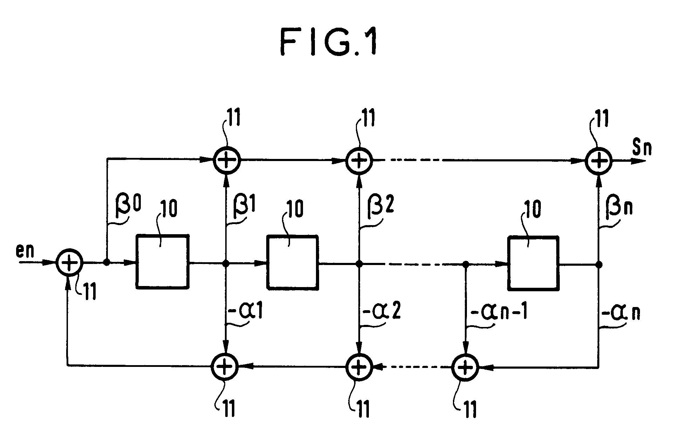

Cette forme par transcription directe donne sous la forme canonique une architecture du type représenté à la figure 1 avec des éléments 10 correspondant aux retards "temps-bit" $Z^{-1}$ (ou retards fonctionnels), et des additionneurs 11, $e_n$ étant l'entrée et $s_n$ la sortie.

Pour évaluer les coefficients de tels filtres il existe différentes méthodes.
- Filtrage temporel lorsque les caractéristiques du filtre sont connues dans le temps ;
- Filtrage fréquentiel lorsque les caractéristiques fréquentielles sont connues ;
- filtrage optimal qui a partir d'un gabarit et d'un critère (moindre carré) cherche à optimiser ce dernier.

Toutes ces méthodes conduisent à l'utilisation d'un algorithme implanté sur un calculateur permettant d'obtenir les réponses désirées de phase et d'amplitude sans avoir besoin par la suite d'optimiser ces calculs sur la maquette. Une telle réalisation est donc aisée.

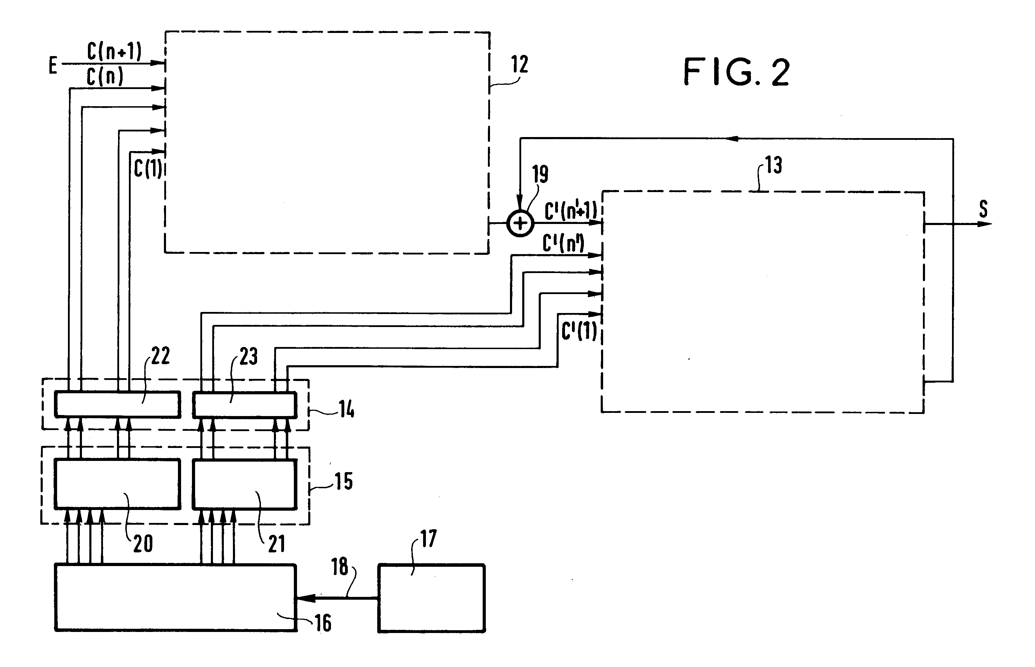

Comme représenté à la figure 2, le filtre de l'invention comprend :
- un filtre transverse 12 ;
- un filtre récursif 13 ;
- un dispositif de mémorisation 15 des différents coefficients de ces deux filtres suivi d'un dispositif convertisseur numérique-analogique 14;
- un dispositif d'adressage 16 de ce dispositif de mémorisation ;
- un organe de commande 17 de ce dispositif d'adressage.

L'organe de commande 17 est relié par un bus 18 au dispositif d'adressage 16, qui peut être un registre à décalage, dont les sorties sont reliées au dispositif de mémorisation 15 constitué par exemple de deux mémoires 20, 21, PROM Par exemple ("Programmable Read only Memory").

Les sorties de ces deux mémoires 20, 21 sont respectivement reliées aux n entrées C(1)...C(n) et aux n' entrées C'(1)...C'(n') des deux filtres transverse 12 et récursif 13 par l'intermédiaire de deux convertisseurs numérique-analogique 22, et 23 par exemple.

Le filtre transverse 12 comprend une entrée supplémentaire C(n + 1) qui est l'entrée E du filtre de l'invention. La sortie de ce filtre transverse est reliée à un additionneur intermédiaire 19 dont la sortie qui constitue la sortie S du filtre de l'invention, est reliée à une entrée supplémentaire C'-(n' + 1) du filtre récursif 13.

La sortie de ce filtre récursif 13 est reliée à la deuxième entrée de cet additionneur intermédiaire 19.

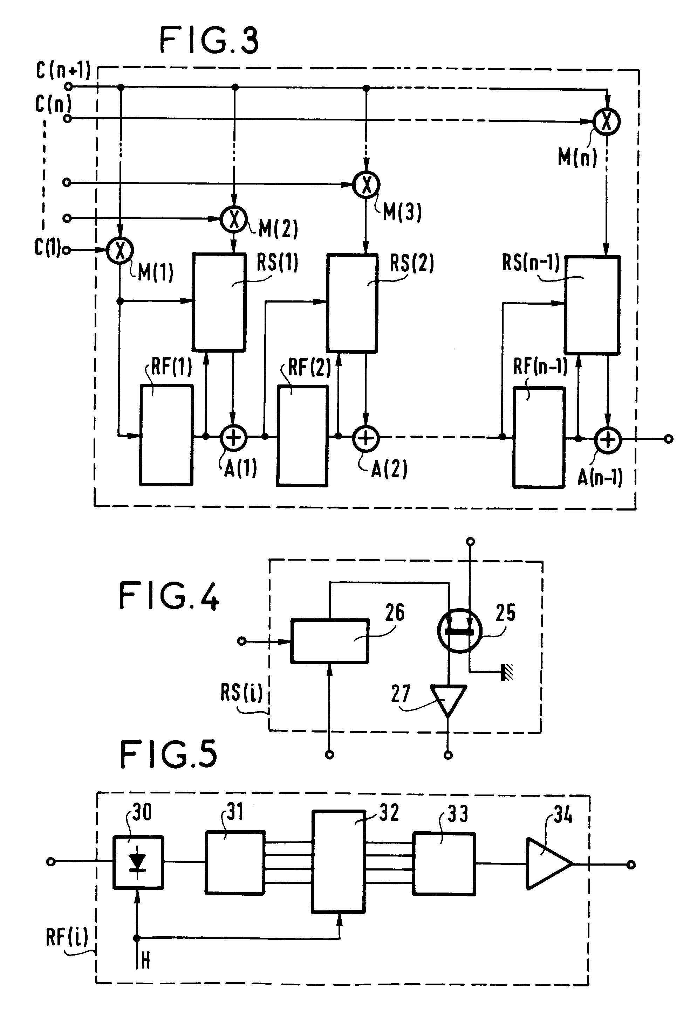

Le filtre transverse 12 et le filtre récursif 13 peuvent avoir chacun une structure telle que représentée à la figure 3.

Une telle structure comprend n-1 éléments de retard fonctionnels RF(1)...RF(n-1) en série avec n-1 additionneurs A(1)...A(n-1), un additionneur A(i) étant disposé à la sortie de chaque élément de retard RF(i), n-1 éléments de retard structurel RS-(1)...RS(n-1), n multiplieurs M(1)....M(n) dont les premières entrées sont reliées aux n entrées C(1)-...C(n), et dont les secondes entrées sont reliées à l'entrée C (n + 1).

Chaque élément de retard structurel RS(i) a une première entrée reliée à la sortie du multiplieur de rang immédiatement supérieur M(i + 1), une seconde entrée reliée à l'entrée de l'élément de retard fonctionnel de même rang RF(i), une troisième entrée reliée à la sortie du même élément de retard fonctionnel RF(i) et sa sortie reliée à la deuxième entrée de l'additionneur de même rang A(i).

Le premier multiplieur M(1) a sa sortie qui est reliée à l'entrée du premier élément de retard fonctionnel RF(1).

Mais chacun de ces deux filtres 12 et 13 peut avoir un nombre d'entrées, et donc un nombre d'éléments de retard différent par rapport à l'autre.

Un élément de retard structurel RS (i) comprend, comme représenté à la figure 4, un transistor FET bigrille 25 dont l'une des grilles constitue la première entrée, et dont la seconde grille est reliée à la sortie d'un discriminateur de phase 26 dont les deux entrées constituent respectivement la seconde et la troisième entrée dudit élément.

le drain dudit transistor bigrille 25 est relié à la masse, alors que la source est reliée à un amplificateur séparateur 27 dont la sortie constitue la sortie dudit élément de retard structurel.

Chaque discriminateur de phase compare les signaux entre l'entrée et la sortie d'un opérateur fonctionnel $Z^{-1}$. La tension d'erreur est appliquée avec l'amplitude et la phase initiale correcte à la seconde grille du transistor 25, ou d'une chaîne de transistors FET bigrilles, qui par variation de polarisation provoquent le déphasage nécessaire en fréquence intermédiaire soit une période à 70MHz $\simeq$ 14,29ns.

Comme représenté à la figure 5, l'élément de retard fonctionnel RF(i) ou retard "temps bit", comporte en série :

- un échantillonneur 30, par exemple à diode PIN ;
- un convertisseur analogique-numérique 31 ;
- un registre à décalage 32 ;
- un convertisseur numérique-analogique 33 ;
- un amplificateur séparateur 34.

Le retard fonctionnel, ou retard "temps bit", sera par exemple de 500ns à 2Mbits. Il résulte de l'association de plusieurs fonctions équivalent à une chaîne d'acquisition de données.

Dans l'échantillonneur à diode PIN 30, le signal à fréquence intermédiaire (FI) est découpé à une fréquence d'échantillonnage FS = kFI, par exemple FS = 10 FI.

Ce signal est ensuite numérisé par le convertisseur analogique-numérique 31.

Le signal issu de ce convertisseur 31 est codé en un nombre d'états numériques suivant la loi $2^{n(bits)}$.

Ainsi par exemple pour un convertisseur analogique-numérique 700MHz, 6 bits, le signal de sortie sera codé sur 64 états. Le nombre d'états contribue à la qualité spectrale du signal de sortie. En effet l'augmentation du nombre des bits entraîne une diminution du rapport signal/bruit.

Ce signal codé est mémorisé dans le registre à décalage 32 dont l'importance dépendra du retard à obtenir.

Dans l'exemple choisi, avec 2Mbits et une fréquence d'échantillonnage de 700MHz le nombre

de registres =

$$\frac{500ns}{1,429ns} \approx 350$$

Cette grande quantité d'éléments est tout à fait possible, le niveau d'intégration des éléments actifs étant de l'ordre de $10^5$ à $10^6$/cm$^2$.

Chaque information est ensuite "lue" au rythme de l'échantillonnage avec le retard correspondant au nombre de registres. La conversion numérique-analogique est ensuite opérée par le circuit approprié 33. Ce signal est ensuite appliqué à l'additionneur A(i) par l'intermédiaire de l'amplificateur séparateur 34.

En cas de variation du débit on adapte le filtre de l'invention en modifiant la configuration des coefficients des deux filtres.

En effet les deux filtres ont une structure identique mais leurs coefficients sont différents.

Les mémoires PROM permettent la mémorisation des coefficients numérisés de chacun des deux filtres, qui après conversion numérique-analogique vont attaquer les multiplieurs.

Ces multiplieurs M(i) peuvent réalisés à l'aide de transistors classiques pouvant fonctionner au moins à 70MHz.

L'adressage des mémoires 20 et 21 par le registre a décalage, qui permet l'identification de nouveaux coefficients, est réalisé par exemple au moyen d'un microprocesseur 17.

Le filtre selon l'invention se différencie donc de filtres classiques par le fait que chaque composante du spectre à filtrer est traitée séparément à l'aide de coefficients en amplitude et en phase, l'ensemble constituant une fonction de transfert. La phase ou le retard fonctionnel est obtenu par l'ensemble d'éléments représentés sur la figure 5. Alors que dans le filtrage classique l'ensemble du spectre subit l'action de la fonction de transfert du filtre constitué de composants passifs, selfs et capacités, localisés ou non.

Tout retard parasite du au montage dégrade de façon rédhibitoire le fonctionnement du filtre car il agit à contrario du "retard fonctionnel". Il s'agit du retard des composants de base : multiplieurs, additionneurs, lignes ou connexions, amplificateurs, si besoin est, ect... que l'on a appelé "retard structurel". Ce retard est compensé à chaque élément du filtre, plus correctement à chaque pôle par un dispositif à FET ("Field Effect Transistor") bigrille qui a la particularité de déphaser le signal à fréquence intermédiaire transitant par un des chemins grille-drain par une polarisation du deuxième chemin, deuxième grille-drain. Le système est automatisé car il est convergent. Le niveau ou l'état de la polarisation de la deuxième grille est établi quand le discriminateur de phase 26 donne un signal nul à sa sortie.

Il est d'ailleurs possible de "cascader" ou mettre en série autant de transistors bigrilles 25 qu'il sera nécessaire pour obtenir le déphasage voulu (un FET bigrille à des fréquences d'environ 100 MHz ne peut souvent pas présenter plus de 30° de déphasage).

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.

## Revendications

1.  Filtre numérique fonctionnant à fréquence intermédiaire, caractérisé en ce qu'il comprend :
    - un filtre transverse (12) ;
    - un filtre récursif (13) ;
    - un dispositif de mémorisation (15) des différents coefficients des deux filtres ;
    - un dispositif de conversion numérique-analogique (14) situé en sortie de ce dispositif de mémorisation (15) ;
    - un dispositif d'adressage (16) de ce dispositif de mémorisation ;
    - un organe de commande (17) de ce dispositif d'adressage ;
    
    et en ce que le dispositif de conversion numérique-analogique (14) reçoit en entrée les sorties parallèles du dispositif de mémorisation, et a ses sorties reliées respectivement aux n entrées du filtre transverse (12) et aux n' entrées du filtre récursif (13), et en ce que le filtre transverse (12) comprend une $n+1^e$ entrée qui est l'entrée (E) dudit filtre, la sortie de ce filtre transverse étant reliée à la première entrée d'un additionneur intermédiaire (19) dont la sortie, qui constitue la sortie (S) dudit filtre, est reliée à la $n'+1^{ème}$ entrée du filtre récursif (13), la sortie de ce filtre récursif étant reliée à la deuxième entrée de l'additionneur intermédiaire (19).

2.  Filtre selon la revendication 1, caractérisé en ce que le filtre transverse (12) et le filtre récursif (13) sont de structures analogues.

3.  Filtre selon la revendication 2, caractérisé en ce qu'une telle structure comprend n-1 éléments de retards fonctionnels (RF(i)) reliés en série avec n-1 additionneurs (A(i)), un additionneur étant disposé à la sortie de chaque élément de retard fonctionnel, n-1 éléments de retards structurels (RS(i)) et n multiplieurs (M-(i)) à la première entrée desquels sont reliées n entrées (C(i)) et dont la seconde entrée est reliée à une dernière entrée (C(n+1)), en ce que chaque élément de retard structurel (RS(i)) a une première entrée reliée à la sortie du multiplieur de rang immédiatement supérieur (M (i+1)), une seconde entrée reliée à l'entrée de l'élément de retard fonctionnel de même rang (RF(i)), une troisième entrée reliée à la sortie du même élément de retard fonctionnel (RF(i)) et sa sortie reliée à la deuxième entrée de l'additionneur de même rang (A(i)), et en ce que le premier multiplieur (M(1)) a sa sortie qui est reliée à l'entrée du premier élément de retard fonctionnel (RF(1)).

4.  Filtre selon l'une quelconque des revendications précédentes, caractérisé en ce que chaque élément de retard structurel (RS(i)) comprend au moins un transistor FET bigrille dont l'une des grilles constitue la première entrée, et dont la seconde grille est reliée à la sortie d'un discriminateur de phase (26) dont les deux entrées constituent respectivement la seconde et la troisième entrée dudit élément de retard, le drain dudit transistor étant relié à la masse, alors que sa source est reliée à un amplificateur-séparateur (27) dont la sortie constitue la sortie dudit élément de retard.

5.  Filtre selon l'une quelconque des revendications précédentes, caractérisé en ce que l'élément de retard fonctionnel comporte en série :
    - un échantillonneur (30) ;
    - un convertisseur analogique-numérique (31) ;
    - un registre à décalage (32) ;
    - un convertisseur numérique-analogique (33) ;
    - un amplificateur séparateur (34).

6.  Filtre selon la revendication 5, caractérisé en ce que l'échantillonneur (30) est un échantillonneur à diode PIN.

7.  Filtre selon l'une quelconque des revendications précédentes, caractérisé en ce que le dispositif de mémorisation (15) comprend au moins une mémoire PROM (20) ("Programmable Read Only Memory").

8.  Filtre selon l'une quelconque des revendications précédentes, caractérisé en ce que le dispositif d'adressage (16) comprend un registre à décalage.

9.  Filtre selon l'une quelconque des revendications précédentes, caractérisé en ce que l'organe de commande comprend un microprocesseur.

## Claims

1. A digital filter operating at intermediate frequency, characterized in that it comprises:
   - a transverse filter (12),
   - a recursive filter (13),
   - a device (15) for storing the different coefficients of the two filters,
   - a D-A conversion device (14) situated at the output of this storage device (15),
   - a device (16) for addressing this storage device (15),
   - a means (17) for controlling this addressing device,

   and in that the D-A conversion device (14) receives as input the parallel outputs of the storage device, and has its outputs connected respectively to the n inputs of the transverse filter (12) and to the n' inputs of the recursive filter (13), and that the transverse filter (12) comprises an $(n+1)^{st}$ input which is the input (E) of said filter, the output of said transverse filter being connected to the first input of an intermediate adder (19), whose output, which forms the output (S) of the filter, is connected to the $(n'+1)^{st}$ input of the recursive filter (13), the output of this recursive filter being connected to the second input of the intermediate adder (19).

2. A filter according to claim 1, characterized in that the transverse filter (12) and the recursive filter (13) have similar structures.

3. A filter according to claim 2, characterized in that such a structure comprises n-1 functional delay elements (RF(i)) connected in series with n-1 adders (A(i)), an adder being disposed at the output of each functional delay element, n-1 structural delay elements (RS(i)) and n multipliers (M(i)) to the first input of which are connected n inputs (C(i)) and whose other input is connected to a last input (C(n+1)), and that each structural delay element (RS(i)) has a first input connected to the output of the multiplier of immediately higher rank (M(i+1)), a second input connected to the input of the functional delay element of the same rank (RF(i)), a third input connected to the output of the same functional delay element (RF(i)) and its output connected to the second input of the adder of the same rank (A(i)), and that the first multiplier (M(1)) has its output connected to the input of a first functional delay element (RF(1)).

4. A filter according to any one of the preceding claims, characterized in that each structural delay element (RS(i)) includes at least one twin gate FET transistor, one of whose gates constitutes the first input and the second gate of which is connected to the output of a phase discriminator (26) whose two inputs form respectively the second and third input of said delay element, the drain of said transistor being grounded, whereas its source is connected to a separator amplifier (27) whose output forms the output of said delay element.

5. A filter according to any one of the preceding claims, characterized in that the functional delay element includes in series:
   - a sampler (30);
   - an A-D converter (31),
   - a shift register (32),
   - a D-A converter (33),
   - a separator-amplifier (34).

6. A filter according to claim 5, characterized in that the sampler (30) is a PIN diode sampler.

7. A filter according to any one of the preceding claims, characterized in that the storage device (15) includes at least one PROM (Programmable Read Only Memory).

8. A filter according to any one of the preceding claims, characterized in that the addressing device (16) includes a shift register.

9. A filter according to any one of the preceding claims, characterized in that the control unit includes a microprocessor.

## Patentansprüche

1. Digitales Zwischenfrequenzfilter, dadurch gekennzeichnet, daß es aufweist:
   - ein Transversalfilter (12),
   - ein Rekursivfilter (13),
   - eine Speichereinrichtung (15) für die verschiedenen Koeffizienten der beiden Filter,
   - einen Digital-Analog-Wandler (14) am Ausgang der Speichereinrichtung (15),
   - eine Adressiereinrichtung (16) für die Speichereinrichtung,
   - eine Steuereinheit (17) für die Adressiereinrichtung,

   daß der Eingang des Digital-Analog-Wandlers (14) mit den parallelen Ausgängen der Speichereinrichtung verbunden ist, während seine Ausgänge mit den n Eingängen des Transversalfilters (12) bzw. den n' Eingängen des Rekursivfilters (13) verbunden sind, und daß das Transversalfilter (12) einen n+1-ten Eingang aufweist, der den Eingang (E) dieses Filters bildet, während der Ausgang dieses Transversalfilters mit dem ersten Eingang eines Zwischenaddierers (19) verbunden ist, dessen Ausgang, der zugleich den Ausgang (S) des Filters bildet, mit dem n' + 1-ten Eingang des Rekursivfilters (13) verbunden ist, wobei der Ausgang des Rekursivfilters mit dem zweiten Eingang des Zwischenaddierers (19) verbunden ist.

2. Filter nach Anspruch 1, dadurch gekennzeichnet, daß das Transversalfilter (12) und das Rekursivfilter (13) analog strukturiert sind.

3. Filter nach Anspruch 2, dadurch gekennzeichnet, daß eine solche Struktur n-1 funktionelle Verzögerungselemente (RF(i)), die mit n-1 Addiergliedern (A(i)) in Reihe geschaltet sind, wobei ein Addierglied am Ausgang jedes funktionellen Verzögerungselements angeordnet ist, sowie n-1 strukturelle Verzögerungselemente (RS(i)) und n Multiplizierglieder (M(i)) aufweist, mit deren erstem Eingang n Eingänge (C(i)) verbunden und deren zweiter Eingang an einen letzten Eingang (C(n + 1)) angeschlossen ist, daß jedes strukturelle Verzögerungselement (RS(i)) über einen ersten Eingang an den Ausgang des unmittelbar ranghöheren Multiplizierglieds (M(i + 1)), über einen zweiten Eingang mit dem Eingang des gleichrangigen funktionellen Verzögerungselements (RF(i)), über einen dritten Eingang mit dem Ausgang desselben funktionellen Verzögerungselements (RF-(i)), und über seinen Ausgang mit dem zweiten Eingang des gleichrangigen Addierglieds (A(i)) verbunden ist, und daß das erste Multiplizierglied (M(1)) mit seinem Ausgang an den Eingang des ersten funktionellen Verzögerungselements (RF(1)) angeschlossen ist.

4. Filter nach einem beliebigen der vorhergehenden Ansprüche, dadurch gekennzeichnet, daß jedes strukturelle Verzögerungselement (RS(i)) mindestens einen Feldeffekttransistor FET mit zwei Gittern aufweist, wovon eines einen ersten Eingang bildet und das zweite mit dem Ausgang eines Phasendiskriminators (26) verbunden ist, dessen beide Eingänge den zweiten bzw. den dritten Eingang des Verzögerungselements bilden, wobei das Drain des Transistors mit der Masse verbunden ist, während die Source an einen Trennverstärker (27) angeschlossen ist, dessen Ausgang den Ausgang des Verzögerungselements bildet.

5. Filter nach einem beliebigen der vorhergehenden Ansprüche, dadurch gekennzeichnet, daß das funktionelle Verzögerungselement in Reihenschaltung aufweist
- einen Abtaster (30),
- einen Analog-Digital-Wandler (31),
- ein Schieberegister (32),
- einen Digital-Analog-Wandler (33),
- einen Trennverstärker (34).

6. Filter nach Anspruch 5, dadurch gekennzeichnet, daß der Abtaster (30) ein PIN-Diodenabtaster ist.

7. Filter nach einem beliebigen der vorhergehenden Ansprüche, dadurch gekennzeichnet, daß die Speichereinrichtung (15) mindestens einen Speicher vom Typ PROM (20) ("programmierbarer Festspeicher") aufweist.

8. Filter nach einem beliebigen der vorhergehenden Ansprüche, dadurch gekennzeichnet, daß die Adressiereinrichtung (16) ein Schieberegister aufweist.

9. Filter nach einem beliebigen der vorhergehenden Ansprüche, dadurch gekennzeichnet, daß die Steuereinheit einen Mikroprozessor aufweist.

# FIG.1

FIG.2

FIG.3

FIG.4

FIG.5